(19) **Europäisches Patentamt**
**European Patent Office**
**Office européen des brevets**

(11) **EP 2 036 413 B1**

(12) **EUROPEAN PATENT SPECIFICATION**

(45) Date of publication and mention
of the grant of the patent:
**04.05.2011 Bulletin 2011/18**

(51) Int Cl.:
**H05K 5/00** *(2006.01)*

(21) Application number: **07768898.4**

(86) International application number:
**PCT/NL2007/000169**

(22) Date of filing: **05.07.2007**

(87) International publication number:
**WO 2008/004862 (10.01.2008 Gazette 2008/02)**

(54) **HOUSING AND METHOD FOR KEEPING DRY AN ELECTRONIC CIRCUIT**

GEHÄUSE UND VERFAHREN ZUM TROCKENHALTEN EINER ELEKTRONISCHEN SCHALTUNG

BOÎTIER ET PROCÉDÉ POUR MAINTENIR UN CIRCUIT ÉLECTRONIQUE AU SEC

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **05.07.2006 NL 1032115**

(43) Date of publication of application:
**18.03.2009 Bulletin 2009/12**

(73) Proprietor: **Kamstrup B.V.**
**6983 BP Doesburg (NL)**

(72) Inventor: **LANGEVELD, Jacobus, Franciscus, Age**
**NL-6711 EK Ede (NL)**

(74) Representative: **Grootscholten, Johannes A.M. et al**
**Arnold & Siedsma**
**Sweelinckplein 1**
**2517 GK Den Haag (NL)**

(56) References cited:
**EP-A- 0 377 067       EP-A- 1 784 066**
**EP-A1- 0 186 543      DE-A1- 19 652 926**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The present invention relates to a housing for keeping at least one electronic circuit in a substantially dry state. The invention also relates to an assembly of such a housing, an electronic circuit and a power supply therefor, in addition to a drying means for drying the air inside the housing. Finally, the invention relates to method for keeping an electronic circuit in a substantially dry state in a housing.

Casings or housings are applied for the protection of electronic equipment, such as for instance measuring equipment, telecommunication equipment and the like, in humid conditions, in particular when such equipment is disposed in the open air. Such housings ensure that the functioning of the equipment is impeded as little as possible by incoming moisture.

In the design of such housings it is necessary to find a good balance between protection of the electronic equipment against moisture, the costs of the housing and the susceptibility to maintenance of the housing and/or of the equipment arranged in the housing. Gastight closure of a housing to be placed in a humid environment such that the interior of the housing remains almost completely dry can be realized technically. Such housings and the closing means therefor are however rather expensive and are moreover often embodied such that access to the electronic equipment, for instance to carry out maintenance thereof, is made difficult. After the housing has been opened for maintenance purposes and the maintenance has been carried out, it is often also impossible in practice to reclose the housing in sufficiently gastight manner. When the electronic equipment consists for instance of a measuring apparatus of a heating system powered by a battery and/or accumulator, which measuring apparatus must function in a humid environment for a long period of time, the housing will have to be opened every few years in order to change or recharge the accumulator and/or battery/batteries. Means for sealing the housing sufficiently well that the measuring apparatus, for instance an energy meter or a circuit for the purpose of recording measured values of one or more energy meters, can function properly for several years, are technically difficult to realize, take up a relatively large amount of space and are expensive.

Such housings are embodied in practice with a seal which is insufficient to keep the interior of the housing sufficiently dry in the longer term (one or more years) in order to avoid malfunction in the electronic equipment. In order to keep the air humidity in the housing low, it is deemed known to arrange a drying means in the housing, for instance in the form of one or more bags of silica gel. Silica gel has the property of absorbing moisture. Moisture is extracted from the space in the housing by the moisture absorption. If the electronic equipment must be kept dry for quite a long period of time, this would however mean that unacceptably large quantities of drying means would have to be arranged in the housing, which increases the dimensions required for the housing and further increases costs.

Housings are further known in which the wall of the housing is provided with a passage closed with a membrane for the purpose of preventing entry of moisture in the liquid phase resulting from pressure difference between the interior of the housing and the outside environment, for instance due to differences in inside and outside temperature, wherein the membrane is of a type which substantially blocks moisture in liquid phase but is substantially permeable to air and water vapour.

A drawback of the latter housings is that the resistance over the membrane must be relatively small in order to be able to follow pressure changes sufficiently rapidly, which means that the dimensions of such a membrane become impractically large. Such strong pressure changes can occur if heating by direct sunlight is for instance alternated with cooling by rain or hail, the atmospheric pressure changes rapidly as the weather type changes, or due to the very rapid displacement of the setup, as when applied in aircraft.

The dimensions of the membrane hereby become so large that diffusion of moisture through the membrane once again makes the application of impractical quantities of drying means necessary. This means that an (excessively) large part of the volume of the housing must be filled with drying means.

It is an object of the present invention to provide a housing and method in which the above stated drawbacks of the prior art are obviated.

It is also an object of the present invention to provide a housing and method in which realizing and maintaining a relatively low relative air humidity inside the housing can be effected more easily in an environment with a relatively high air humidity.

It is a further object of the present invention to provide such a housing which can be opened and closed relatively easily so as to enable easy access to the interior of the housing, for instance with a view to repair or maintenance.

According to prior art as known from EP-0.377.067, a housing is provided for keeping at least one electronic circuit in a substantially dry state, the housing comprising:

- a closable container which is adapted to contain the electronic circuit, on which container can be arranged a closing element for closing the electronic circuit from the outside environment;
- at least one passage which is arranged in the container and/or the closing element and along which moisture and air can be transported;
- at least one diffusion resistor arranged in the passage for reducing the moisture diffusion via the passage between the interior of the container and the outside environment.

Relative to the prior art as known from EP-0.377.067 the invention is novel in that a ratio (R) of the volume (V) of the housing, multiplied by the channel length (1) of the diffusion resistor divided by the channel area (A) in cross-section of the diffusion resistor, is at least about 30. This results in a diffusion resistance with which the required low air humidity can be realized in the housing for a longer period of time (at least one year, in practice about 5 years or more).

Pressure differences can be equalized via the passage, which greatly reduces the drawing-in of moisture. The effect of moisture diffusion via the passage is moreover greatly reduced by arranging the diffusion resistor. The added diffusion resistor has little influence on the flow resistance of the whole, but considerably reduces the diffusion.

According to a first preferred embodiment, a moisture resistor is also arranged in the passage, preferably comprising at least one membrane which is adapted to substantially prevent transport of moisture in the liquid phase and to substantially allow transport of air and moisture in the vapour phase. In a determined preferred embodiment the membrane is manufactured from an expanded polytetrafluoroethylene (ePTFE), although application of other materials is also possible.

According to a further preferred embodiment, the moisture resistor and diffusion resistor are arranged in series, which means that the gases or liquids transported through the passage must always pass through both the moisture resistor and the diffusion resistor.

According to a further preferred embodiment, the diffusion resistor comprises an elongate diffusion element provided with a channel and with a predetermined minimal ratio of channel section (A) and channel length (1). The diffusion element can for instance be a cylindrical block in which a narrow channel is provided. Other forms and embodiments of a diffusion element can however also be envisaged.

In a further preferred embodiment ventilation means are provided in the container and/or the closing element, which are adapted to be switched on from a preset overpressure or underpressure for the purpose of ventilating the container. The ventilation means provide a more rapid equalization of pressure in the case of great pressure and/or temperature changes in the outside environment. Such great pressure changes would otherwise load the housing too heavily, and particularly the diffusion and/or moisture resistance thereof. The ventilation means preferably comprise a self-closing overpressure valve and/or an underpressure valve, and more preferably a double-action valve, with which the housing is ventilated from a preset underpressure or overpressure. The value of said preset minimal underpressure depends on the specific application.

According to a further preferred embodiment, at least a second moisture resistor is connected to the ventilation means to substantially prevent transport of moisture in the liquid phase and substantially allow transport of air and moisture in the vapour phase when the ventilation means are switched on. The membrane can be of the same type as already described above.

In a particularly advantageous embodiment the moisture resistor comprises a membrane holder provided with a membrane, wherein the diffusion resistor comprises a diffusion element mounted on the membrane holder. A handy and compact unit can be obtained by integrating the moisture resistor and diffusion resistor in a membrane holder. When use is for instance made of prefabricated membranes and membrane holders, for instance the already existing valves comprising a membrane of the type Gore™ POV, the diffusion elements can be embodied such that they can be readily mounted on the valves comprising a membrane.

According to another aspect of the present invention, there is provided an assembly of an electronic circuit, a power supply therefor, drying means and a housing as defined herein.

In an advantageous embodiment the above stated drying means comprises sodium silicate in a granular and porous form arranged in a (semi-)permeable envelope. Other embodiments of drying means are also possible.

According to a further aspect of the present invention, there is provided a method for keeping an electronic circuit in a substantially dry state in a housing, the method comprising of:

- providing a closable container as defined herein;
- arranging the electronic circuit in the container;
- mounting a closing element on the container for closing the electronic circuit from the outside environment.

Further advantages, features and details of the present invention will be elucidated on the basis of the following description of several preferred embodiments thereof. Reference is made in the description to the accompanying figures, in which:

Figure 1 shows a schematic cross-section of a first preferred embodiment of a housing according to the invention;
Figure 2 shows a schematic cross-section of a second preferred embodiment of the present invention;
Figure 3 shows a first preferred embodiment of a combined diffusion and moisture resistor; and
Figure 4 shows a cross-section through a second preferred embodiment of a combined diffusion and moisture resistor according to the invention.

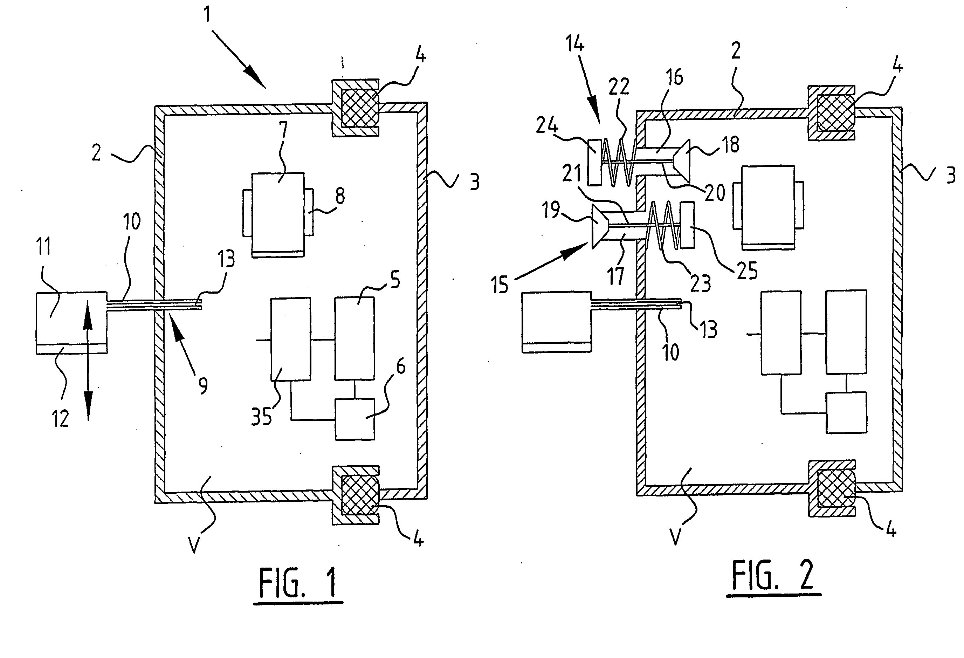

Figure 1 shows a cross-section of a housing for a measuring apparatus of a heating system to be disposed outside. The housing is constructed from a container 2 to which a cover 3 is attached. Provided between cover 3 and container 2 are sealing means, for instance consisting of a belt of silicone material provided all around along the connection of the cover to the container. Using such a belt a reasonably good sealing of the housing can be brought about in relatively simple and inexpensive manner. Electronic equipment, for instance a measuring apparatus 5 connected to an external or internal heat meter, is placed in the housing. The heat meter measures the amount of heat produced by the heating system, and the measuring apparatus stores in a memory measurement data representative of the amount of heat produced. Measuring apparatus 5 is powered with a number of batteries. Telecommunication means 35 are further provided. These are adapted to transmit the measurement data from the measuring apparatus to a central station (not shown) at regular intervals. The telecommunication means comprise for instance GSM module 35, whereby a wireless form of communication is possible. In other embodiments communication can take place via a cable network. Telecommunication means 35 are powered via above stated batteries 6.

In order to protect the electronics 5, 35, for instance the optional contact points of the SIM card of the GSM module, against corrosion for a longer period of time, additional measures must be taken despite the seal 4.

The relative humidity inside the housing must be kept below determined values so as to prevent forming of condensation if the housing is subjected to great changes in ambient temperature and/or atmospheric pressure, so that a good protection of the electric circuits of the equipment, in particular the electrical contacts, can be realized.

Arranged in the wall of container 2 is a passage 9, in which is placed a diffusion resistor in the form of a tubular element 10 provided with a through-feed channel 13. The channel 13 in tubular element 10 has a relatively small diameter and a relatively great length, and hereby forms a diffusion resistor. As a result of the diffusion resistor the entry of moisture, which will take place under stationary conditions (when there is no pressure difference between the housing and the outside environment) as a result of a difference between water vapour pressure in the housing and that outside the housing, is greatly limited. Arranged connecting to tubular element 10 is a membrane holder 11 which is provided with a microporous membrane 12. The membrane is of the type which prevents moisture transport, but further continues to enable the transport of gases (usually air) and vapours (usually water vapour). Membrane 12 hereby forms a moisture resistor. An example of such a membrane is a Goretex™ membrane.

A drying means is also arranged in housing 1. In the shown embodiment drying means 7 comprises a (semi-) permeable envelope in which is arranged sodium silicate, also referred to as silica gel, which has been brought into a granular and porous form. The high porosity of this material ensures that it absorbs water easily, which makes this material particularly suitable as a dessicant. The drying means is fixed to the housing using clamps 8 provided on container 2. Other drying means are however also possible. The amount of drying means is adapted to the desired lifespan of the protection (typically 5 years or more), the amount of moisture which will be introduced during the lifespan as a consequence of ventilation of the housing via the above mentioned diffusion resistor, for instance as a result of the changes in the air temperature in the housing and changes in the air pressure of the atmosphere around the housing, the amount of moisture which will be introduced during the lifespan as a consequence of permeation of moisture through the material of the housing resulting from a difference in water vapour pressure in and outside the housing, and the amount of moisture which will be introduced during the lifespan as a consequence of diffusion of moisture via the above mentioned diffusion resistor as a result of a difference in water vapour pressure in and outside the housing.

Figure 2 shows a second embodiment of the present invention and is applied with larger volumes (V > 10 dm³) and in the case of very marked and rapid temperature and pressure changes. In the case of very marked temperature and pressure changes, for instance in aviation, in large housings, the situation occurs that the housing and sealing of the housing, in which a leak is arranged by means of a diffusion resistor, are loaded by forces as a result of a pressure difference over the flow resistance of the diffusion resistor. These pressure differences can be equalized by arranging an underpressure valve 14 and an overpressure valve 15 in container 2, as shown in Figure 2. Underpressure valve 14 consists of a tube 16 which is arranged in the container and on which rests a closing element 18. Closing element 18 is connected via a connecting part 20 to a component 24 which is under spring tension of a spring 22. In similar manner the overpressure valve 15 consists of a tubular component 17 on which rests a closing element 19. Closing element 19 is connected to a component 25 via a connecting part 21. Component 25 is under spring tension of a spring 23. Underpressure valve 14 is adapted such that, when there is little or no pressure difference between the interior of housing 1 and the outside environment, closing element 18 is pressed against tubular element 16 under the influence of the spring tension, and the housing thus remains closed. If an underpressure occurs, i.e. when the pressure inside the housing is lower than the pressure in the outside environment by more than a predetermined value (for instance in the order of magnitude of 50 mbar), closing element 18 is displaced counter to spring pressure 22 so that an open connection is created between the interior of the housing and the outside environment. In this manner the housing can be ventilated. In wholly analogous manner the overpressure valve 15 can be switched on when the pressure inside the housing is greater than the pressure outside the housing by more than a predetermined value (for instance in the order of magnitude of 50 mbar), so that air can flow from the housing to the outside in order to equalize the pressure difference. This enables a short-term ventilation of the housing.

In order to prevent moisture in the liquid phase being drawn in during the ventilation, a moisture resistor can optionally be arranged in the passage formed by tube 16,17. In such an embodiment (not shown) a Goretex membrane can for instance be arranged and combined with the overpressure/underpressure valves. It is also structurally possible to integrate the overpressure and underpressure valve into a single, double-action valve.

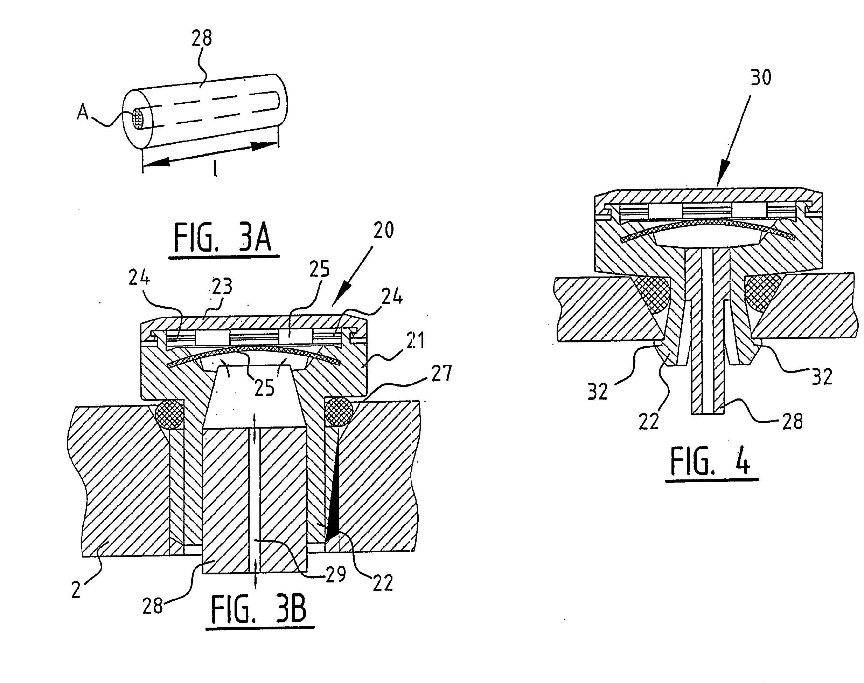

Figures 3 and 4 show particularly advantageous embodiments of an integrated moisture and diffusion resistor. Figure 3 shows a part of the above mentioned container 2. A membrane holder 20 is arranged in the passage. Membrane holder 20 is constructed from a head portion 21, to which connects a cylindrical sleeve 22. A membrane manufactured from expanded polytetrafluoroethylene (ePTFE) is arranged in head portion 21. A cover 23 is fastened onto head portion 21 using supports 24. Openings 25 are provided between supports 24. A passage is created from the bottom end of the sleeve, via the interior of the sleeve and the head portion, up to said openings. The membrane is arranged transversely of this passage. This construction forms a moisture resistor of a per se known type. The outer side of sleeve 22 and the inner side of the passage in container 2 are provided with screw thread so that membrane holder 20 can be screwed in simple manner into said passage of container 2. A closing ring 27 is provided to prevent moisture transport via the connection of membrane holder 20 to container 2. The membrane holder is preferably a valve comprising a membrane of the type POV/M12x1.5 from GORE™ provided with a GORE-TEX® membrane.

According to the invention a diffusion resistor 28 is further arranged in the passage. Diffusion resistor 28 comprises an elongate tube in which a channel 29 is provided. The outer dimensions of tube 28 are chosen here such that it can be mounted fittingly into sleeve 22. As shown in Figure 3a, channel 29 has a length L and a cross-section of A.

Diffusion resistor 28 is herein embodied such that the following formula is satisfied

$$R = \frac{V \times L}{A} > 30$$

wherein V is the volume of the housing to be protected (dm$^3$), A is the cross-sectional area of the diffusion resistor (mm$^2$) and L is the length of the diffusion resistor (mm). It has been found that particularly good results can be achieved when the diffusion resistor is embodied such that said ratio R is greater than about 25, more preferably greater than 30 and most preferably greater than 35. The maximum value of said ratio R is determined in practice by the value of the pressure difference over the housing which is still acceptable, this value depending on the sealing quality of the housing. When the sealing is very good, the desired upper limit can be higher than if the sealing, as determined for instance by the quality of the seal between the container and the closing element of the housing, is relatively poor.

Figure 4 shows another embodiment of a membrane holder 30, which largely corresponds with the embodiment shown in Figure 3. The most important difference is that, instead of using a screw connection, membrane holder 30 can be arranged in the wall of container 2 using resilient lips which are provided with a stop 32. For such an embodiment use can be made of a "snap-in" valve of the type POV/Snap-fit from GORE™. The above mentioned diffusion resistor 28 is in turn inserted into such a known valve so that a series connection of the diffusion resistor and moisture resistor is brought about. Such a combination of diffusion resistor and moisture resistor can be realized in very simple manner, wherein, as described above, use can optionally be made of moisture resistors of already existing types.

In a determined practical application of a housing set up in the open air, the housing is provided with a measuring apparatus, a power supply and a GSM module for the wireless transmission of measured values. The measuring apparatus is connected to an internal or external meter, such as for instance a heat meter and/or a gas meter. The measuring apparatus is suitable for transmitting measurement signals generated by the meter, for instance in the form of pulses of a gas meter or serial communication signals of a heat meter, to a remote station via the GSM module. The signals can herein be transmitted directly, optionally after a processing thereof, but can also be stored temporarily in the measuring apparatus. In the latter case the measurement data is only transmitted to the station once every so often so as to draw as little as possible on the power supply of the measuring apparatus and the GSM module.

In the example of use of a heat meter, diffusion resistor 28 can be embodied with a length L of about 10 mm and a channel section of about 0.8 mm$^2$. If the volume is for instance 3 dm$^3$, the ratio R is about 38. At these values a sufficiently low relative air humidity can be realized for a longer period, typically more than 3 to 5 years.

The present invention is not limited to the preferred embodiments thereof described here. The rights sought are defined by the following claims, within the scope of which further modifications can be envisaged.

**Claims**

1. Housing (1) for keeping at least one electronic circuit (5) in a substantially dry state, the housing comprising:

   - a closable container (2) which is adapted to contain the electronic circuit, on which container can be arranged a closing element (3) for closing the electronic circuit from the outside environment;
- at least one passage (9) which is arranged in the container and/or the closing element and along which moisture and air can be transported;
- at least one diffusion resistor (10) arranged in the passage for reducing the moisture diffusion via the passage between the interior of the container and the outside environment,

wherein the ratio (R) of the volume (V) of the housing, multiplied by the channel length (L) of the diffusion resistor divided by the channel area (A) in cross-section of the diffusion resistor ( $R = V [dm3] * L [mm] / A [mm2]$ )is at least about 30.

2. Housing as claimed in claim 1, wherein a moisture resistor is also arranged in the passage (9).

3. Housing as claimed in claim 2, wherein the moisture resistor comprises at least one membrane (12) which is adapted to substantially prevent transport of moisture in the liquid phase and to substantially allow transport of air and moisture in the vapour phase.

4. Housing as claimed in claim 2 or 3, wherein the moisture resistor and diffusion resistor are arranged in series.

5. Housing as claimed in any of the foregoing claims, wherein ventilation means (14, 15) are provided in the container (2) and/or the closing element (3), which are adapted to be switched on from a preset overpressure or underpressure for the purpose of ventilating the container.

6. Housing as claimed in claim 5, wherein the ventilation means comprise a self-closing overpressure valve (15) and/or an underpressure valve (14), preferably a double-action valve, for ventilating the housing from a minimum underpressure or overpressure.

7. Housing as claimed in claim 6 or 7, wherein the minimum overpressure and/or underpressure is in the order of magnitude of 50 mbar.

8. Housing as claimed in claim 6, 7 or 8, also comprising a second moisture resistor connected to the ventilation means in order to substantially prevent transport of moisture in the liquid phase and to substantially allow transport of air and moisture in the vapour phase when the ventilation means are switched on.

9. Housing as claimed in any of the claims 2-9, wherein the moisture resistor comprises a membrane holder (20) provided with a membrane, and wherein the diffusion resistor comprises a diffusion element mounted on the membrane holder.

10. Housing as claimed in claim 10, wherein the diffusion element is embodied for insertion into the membrane holder (20).

11. Housing as claimed in claim 10 or 11, wherein the membrane holder (20) comprises a fastening part provided with screw thread for the purpose of fastening the membrane holder in a wall of the housing.

12. Housing as claimed in any of the foregoing claims, comprising fixing means for fixing a drying means (7), preferably silica gel, in the housing (2).

13. Assembly of an electronic circuit (5), a power supply, drying means and a housing (1) as claimed in any of the foregoing claims.

14. Assembly as claimed in claim 13, wherein the electronic circuit (5) comprises a measuring apparatus.

15. Method for keeping an electronic circuit (5) in a substantially dry state in a housing (1), the method comprising of:

- providing a closable container (2) as claimed in any of the claims 1-12;
- arranging the electronic circuit (5) in the container;
- mounting a closing element (3) on the container for closing the electronic circuit from the outside environment.

**Patentansprüche**

1. Gehäuse (1) zum Halten wenigstens einer elektronischen Schaltung (5) in einem im wesentlichen trockenen Zustand, wobei das Gehäuse enthält:

- einen verschließbaren Behälter (2), der geeignet ist, die elektronische Schaltung zu enthalten, wobei an dem Behälter ein Verschlusselement (3) angeordnet werden kann, um die elektronische Schaltung von der äußeren Umgebung abzuschließen;
- wenigstens einen Durchlass (9), der in dem Behälter und/oder dem Verschlusselement angeordnet ist und entlang dessen Feuchtigkeit und Luft befördert werden kann;
- wenigstens einen Diffusionswiderstand (10), der in dem Durchlass angeordnet ist, um die Feuchtigkeitsdiffusion durch den Durchlass zwischen dem Inneren des Behälters und der äußeren Umgebung zu reduzieren,

wobei das Verhältnis (R) des Volumens (V) des Gehäuses, multipliziert mit der Kanallänge (L) des Diffusionswiderstandes dividiert durch die Kanalfläche (A) in dem Querschnitt des Diffusionswiderstands (R= V [dm3] * L [mm] / A [mm2]) wenigstens etwa 30 beträgt.

2. Gehäuse nach Anspruch 1,
   wobei auch ein Feuchtigkeitswiderstand in dem Durchlass (9) angeordnet ist.

3. Gehäuse nach Anspruch 2,
   wobei der Feuchtigkeitswiderstand wenigstens eine Membran (12) enthält, die geeignet ist, im wesentlichen das Befördern von Feuchtigkeit in der flüssigen Phase zu verhindern und im wesentlichen das Befördern von Luft und Feuchtigkeit in der Dampfphase zuzulassen.

4. Gehäuse nach Anspruch 2 oder 3,
   wobei der Feuchtigkeitswiderstand und der Diffusionswiderstand in Serie angeordnet sind.

5. Gehäuse nach jedem der vorhergehenden Ansprüche,
   wobei Belüftungsmittel (14,15) in dem Behälter (2) und/oder dem Verschlusselement (3) vorgesehen sind, die geeignet sind, von einem vorbestimmten Überdruck oder Unterdruck zum Zwecke der Belüftung des Behälters eingeschaltet zu werden.

6. Gehäuse nach Anspruch 5,
   wobei die Belüftungsmittel ein selbst-schließendes Überdruckventil (15) und/oder ein Unterdruckventil (14), vorzugsweise ein doppel-wirkendes Ventil enthalten, um das Gehäuse von einem Minimum Unterdruck oder Überdruck zu belüften.

7. Gehäuse nach Anspruch 6 oder 7,
   wobei der minimale Überdruck und/oder Unterdruck in der Größenordnung von 50 mbar ist.

8. Gehäuse nach Anspruch 6, 7 oder 8,
   ferner enthaltend einen zweiten Feuchtigkeitswiderstand, der mit den Belüftungsmitteln verbunden ist, um im wesentlichen das Befördern von Feuchtigkeit in der Flüssigphase zu verhindern und um im Wesentlichen das Befördern von Luft und Feuchtigkeit in der Dampfphase zuzulassen, wenn die Belüftungsmittel eingeschaltet sind.

9. Gehäuse nach jedem der Ansprüche 2 bis 9,
   wobei der Feuchtigkeitswiderstand einen Membranhalter (20) enthält, der mit einer Membran versehen ist, und wobei der Diffusionswiderstand ein Diffusionselement enthält, das an dem Membranhalter befestigt ist.

10. Gehäuse nach Anspruch 10,
    wobei das Diffusionselement zum Einsetzen in den Membranhalter (20) ausgebildet ist.

11. Gehäuse nach Anspruch 10 oder 11,
    wobei der Membranhalter einen Befestigungsteil aufweist, der mit einem Schraubengewinde versehen ist, um den Membranhalter in einer Wand des Gehäuses zu befestigen.

12. Gehäuse nach jedem der vorhergehenden Ansprüche, enthaltend Befestigungsmittel zum Befestigen eines Trockenmittels (7), vorzugsweise Silikagel, in dem Gehäuse (2).

13. Anordnung einer elektronischen Schaltung (5), einer Stromzuführung, Trockenmittel und eines Gehäuses (1) wie nach jedem der vorhergehenden Ansprüche beansprucht.

14. Anordnung nach Anspruch 13,
    wobei die elektronische Schaltung (5) ein Messgerät enthält.

15. Verfahren zum Halten einer elektronischen Schaltung (5) in einem im wesentlichen Trockenen Zustand in einem Gehäuse (1), wobei das Verfahren enthält:

    - Bereitstellen eines verschließbaren Behälters (2) nach jedem der Ansprüche 1 bis 12;
    - Anordnen der elektronischen Schaltung (5) in dem Behälter;
    - Befestigen eines Verschlusselementes (3) an dem Behälter zum Abschließen der elektronischen Schaltung gegenüber der äußeren Umgebung.

**Revendications**

1. Logement (1) pour maintenir au moins un circuit électronique (5) dans un état sensiblement sec, le logement comprenant :

   - un récipient pouvant être fermé (2) qui est conçu pour contenir le circuit électronique, sur lequel récipient un élément de fermeture (3) peut être agencé pour isoler le circuit électronique de l'environnement extérieur ;
   - au moins un passage (9) qui est agencé dans le récipient et/ou l'élément de fermeture et le long duquel l'humidité et l'air peuvent être transportés ;
   - au moins une résistance à la diffusion (10) agencée dans le passage pour réduire la diffusion d'humidité à travers le passage entre l'intérieur du récipient et l'environnement extérieur,

dans lequel le rapport (R) du volume (V) du logement, multiplié par la longueur de canal (L) de la résistance à la diffusion divisé par l'aire de canal (A) en coupe transversale de la résistance à la diffusion (R = V [dm3] * L [mm] /A [mm2]) est au moins d'environ 30.

2. Logement selon la revendication 1, dans lequel une résistance à l'humidité est également agencée dans le passage (9).

3. Logement selon la revendication 2, dans lequel la résistance à l'humidité comprend au moins une membrane (12) qui est conçue pour empêcher sensiblement le transport d'humidité dans la phase liquide et pour permettre sensiblement le transport d'air et d'humidité dans la phase vapeur.

4. Logement selon la revendication 2 ou 3, dans lequel la résistance à l'humidité et la résistance à la diffusion sont agencées en série.

5. Logement selon l'une quelconque des revendications précédentes, dans lequel des moyens de ventilation (14, 15) sont prévus dans le récipient (2) et/ou l'élément de fermeture (3), lesquels sont conçus pour être activés à partir d'une surpression ou d'une sous-pression fixée au préalable afin de ventiler le récipient.

6. Logement selon la revendication 5, dans lequel les moyens de ventilation comprennent une vanne de surpression à fermeture automatique (15) et/ou une vanne de sous-pression (14), de préférence une vanne à double action, pour ventiler le logement à partir d'une sous-pression ou d'une surpression minimum.

7. Logement selon la revendication 5 ou 6, dans lequel la surpression et/ou la sous-pression minimums sont de l'ordre d'amplitude de 50 mbar.

8. Logement selon la revendication 5, 6 ou 7, comprenant également une deuxième résistance à l'humidité raccordée aux moyens de ventilation afin d'empêcher sensiblement le transport d'humidité dans la phase liquide et de permettre sensiblement le transport d'air et d'humidité dans la phase vapeur lorsque les moyens de ventilation sont activés.

9. Logement selon l'une quelconque des revendications 1 à 8, dans lequel la résistance à l'humidité comprend un support de membrane (20) pourvu d'une membrane, et dans lequel la résistance à la diffusion comprend un élément de diffusion monté sur le support de membrane.

10. Logement selon la revendication 9, dans lequel l'élément de diffusion est mis en oeuvre pour une insertion dans le support de membrane (20).

11. Logement selon la revendication 9 ou 10, dans lequel le support de membrane (20) comprend une partie de fixation pourvue d'un filet de vis afin de fixer le support de membrane dans une paroi du logement.

12. Logement selon l'une quelconque des revendications précédentes, comprenant des moyens de fixation pour fixer des moyens de séchage (7), de préférence du gel de silice, dans le logement (2).

13. Assemblage d'un circuit électronique (5), d'une alimentation, de moyens de séchage et d'un logement (1) selon l'une quelconque des revendications précédentes.

14. Assemblage selon la revendication 13, dans lequel le circuit électronique (5) comprend un appareil de mesure.

15. Procédé de maintien d'un circuit électronique (5) dans un état sensiblement sec dans un logement (1), le procédé consistant à :

    - fournir un récipient pouvant être fermé (2) selon l'une quelconque des revendications 1 à 12 ;
    - agencer le circuit électronique (5) dans le récipient ;
    - monter un élément de fermeture (3) sur le récipient pour isoler le circuit électronique de l'environnement extérieur.

FIG. 1

FIG. 2

EP 2 036 413 B1

28

A

l

FIG. 3A

24  23  25  20  24

21

25

27

2

29  22

28

FIG. 3B

30

32

32

22  28

FIG. 4

EP 2 036 413 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0377067 A